# EUROPÄISCHE PATENTSCHRIFT

(11) **EP 3 480 609 B1**
(45) Veröffentlichungstag und Bekanntmachung des Hinweises auf die Patenterteilung: **29.04.2020**
(21) Anmeldenummer: 17199681.2
(22) Anmeldetag: 02.11.2017
(51) Int. Cl.: G01R 31/327, H02H 3/04

(54) **MODIFIZIEREN VON TEST-MESSSIGNALEN FÜR SCHUTZEINRICHTUNGEN FÜR ELEKTRISCHE STROMNETZE**
MODIFICATION OF MEASURING SIGNALS FOR TESTING OF PROTECTION SYSTEMS FOR ELECTRICAL POWER GRIDS
MODIFICATION DES SIGNAUX DE MESURE D'ESSAI POUR DISPOSITIF DE PROTECTION POUR RÉSEAUX ÉLECTRIQUES

(43) Veröffentlichungstag der Anmeldung: 08.05.2019
(73) Patentinhaber: Siemens Aktiengesellschaft, 80333 München (DE)
(72) Erfinder: Canas, Federico, 14612 Falkensee (DE)

(56) Entgegenhaltungen:
- DE-A1-102011 075 645
- DE-A1-102012 011 359
- US-A1- 2003 132 753
- US-A1- 2015 200 534
- US-A1- 2016 003 921

## Beschreibung

Die vorliegende Erfindung betrifft allgemein das technische Gebiet der elektrischen Versorgungsnetze bzw. Stromnetze. Die vorliegende Erfindung betrifft insbesondere eine Vorrichtung sowie ein Verfahren zum Modifizieren von Test-Messsignalen für Schutzeinrichtungen für elektrische Stromnetze.

Stromnetze dienen der Übertragung von elektrischer Energie von Energieversorgungseinrichtungen bzw. Kraftwerken zu elektrischen Verbrauchern. Ein Stromnetz umfasst neben einem Netzwerk von elektrischen Stromleitungen wie Freileitungen und Erdkabel auch andere elektrische Einrichtungen wie Schaltwerke, Umspannwerke und Schutzeinrichtungen. Eine Schutzeinrichtung dient beispielsweise dazu, um bei einer Störung im Netz, beispielsweise ein Kurzschluss, einen von der Störung betroffenen Teil des Stromnetzes von dem Rest des (störungsfrei arbeitenden) Netzes abzutrennen und damit größeren Schaden an dem Netz und/oder an dem Netz angeschlossenen Energie-Einspeiseeinrichtungen und/oder elektrischen Verbrauchern abzuwenden.

Um zum einen eine Störung zuverlässig zu erkennen und zum anderen einen "Fehlalarm" bezüglich einer Störung zu vermeiden, weist eine solche Schutzeinrichtung neben dem eigentlichen Schutzschalter auch noch eine Schutzelektronik (einschließlich einer Software) auf, welche basierend auf Sensorsignalen, welche indikativ sind für Strom- und Spannungspegel an einer bestimmten Messstelle des Stromnetzes, einen Schutzschalter auslöst bzw. betätigt oder nicht. Auch zeitliche Verläufe von Strom- und Spannungspegeln können ausgewertet werden, um zu entscheiden, ob tatsächlich eine Störung vorliegt, welche ein Auslösen des eigentlichen Schutzschalters erfordert.

Die elektrischen Messgrößen Spannung bzw. Strom, welche an einer Messstelle des Stromnetzes vorliegen, können abhängig von dem jeweiligen Stromnetz und des aktuellen Zustands des Stromnetzes sehr hoch, beispielsweise 380.000 Volt (V) bzw. 3000 Ampere (A) sein. Daher ist es erforderlich, die Pegel dieser Messgrößen in geeigneter Weise zu reduzieren, damit sie von der Schutzeinrichtung empfangen und von deren Elektronik ausgewertet werden können. Eine solche Reduzierung auf Messsignale in der Größenordnung von 100 V bzw. 1 oder 5 A nominal kann in bekannter Weise mittels Transformatoren erfolgen. Anstelle von solchen Transformatoren können jedoch auch andere elektrische Wandler verwendet werden, welche deutlich niedrigere Messsignale in der Größenordnung von wenigen Volt (V) und wenigen Milliampere (mA) bereitstellen. Solch niedrige Messsignale werden in diesem Dokument auch als Kleinmesssignale bezeichnet. Wandler, welche solche Kleinmesssignale bereitstellen, werden in diesem Dokument auch als Kleinsignalwandler bezeichnet. Dazu passende Schutzeinrichtungen mit einer entsprechend empfindlichen Elektronik zum Auswerten der Kleinmesssignale werden in entsprechender Weise als Kleinsignal-Schutzeinrichtungenbezeichnet, welche eine "Kleinsignal-Elektronik" (einschließlich einer "Kleinsignal-Software") aufweisen.

Aus Gründen der Betriebssicherheit müssen solche (Kleinsignal-) Schutzeinrichtungen und insbesondere deren Elektronik genau getestet werden können. Hierbei ist es offensichtlich, dass solche Tests nicht während eines realen Betriebs ausgeführt werden. Daher wurden Test-Generatoren entwickelt, welche die Funktion der vorstehend beschriebenen und an einem Stromnetz angeschlossenen Transformatoren emulieren und künstliche Test-Messsignale bereitstellen, welche zum Testen der Schutzeinrichtungen verwendet werden. Bekannte Test-Generatoren sind aufgrund ihrer elektrischen Ausgangscharakteristik jedoch nicht in der Lage, auch künstliche Test-Kleinmesssignale zum Testen von Kleinsignal-Schutzeinrichtungen bereitzustellen.

Aus der DE 10 2012 011 359 A1 ist eine Messvorrichtung zum Bestimmen der Schaltzeit eines Leistungsschalters bekannt, die über einen Adapter an einen Messsensor angeschlossen ist.

Der vorliegenden Erfindung liegt die Erkenntnis zugrunde, die Funktionalität von Test-Generatoren auf einfache Weise dahingehend zu erweitern, dass verschiedenen Arten von Schutzeinrichtungen mit unterschiedlichen elektrischen Charakteristika auf ihre Funktionsfähigkeit hin getestet werden können.

Diese Aufgabe wird gelöst durch die Gegenstände der unabhängigen Patentansprüche. Vorteilhafte Ausführungsformen, weitere Merkmale und Details der vorliegenden Erfindung ergeben sich aus den abhängigen Ansprüchen, der Beschreibung und der Zeichnung. Dabei gelten Merkmale und Details, die im Zusammenhang mit der Vorrichtung beschrieben sind, selbstverständlich auch im Zusammenhang mit dem Verfahren und umgekehrt, so dass bezüglich der Offenbarung dieser Erfindung zu den einzelnen Erfindungsaspekten stets wechselseitig Bezug genommen werden kann.

Gemäß einem ersten Aspekt der Erfindung wird eine Vorrichtung zum Modifizieren von Test-Messsignalen für Schutzeinrichtungen für elektrische Stromnetze beschrieben. Die Vorrichtung weist auf (a) eine Eingangsschnittstelle zum Empfangen eines ersten Test-Messsignales von einem Test-Generator, wobei das erste Test-Messsignal abgestimmt ist auf eine erste elektrische Eingangscharakteristik einer ersten Schutzeinrichtung für ein Stromnetz; (b) ein mit der Eingangsschnittstelle gekoppeltes elektrisches Modifizierungssystem zum Umwandeln des ersten Test-Messsignales in ein zweites Test-Messsignal, wobei das zweite Test-Messsignal abgestimmt ist auf eine zweite elektrische Eingangscharakteristik einer zweiten Schutzeinrichtung für das Stromnetz; und (c) eine Ausgangsschnittstelle zum Ausgeben des zweiten Test-Messsignales an die zweite Schutzeinrichtung.

Erfindungsgemäß weist die Eingangsschnittstelle einen Eingangs-Stromanschluss auf. Alternativ oder in Kombination weist die Ausgangsschnittstelle einen Ausgangs-Stromanschluss auf. Der Eingangs-Stromanschluss umfasst dabei bevorzugt zumindest zwei Anschlussklemmen. Diese können beispielsweise mit einfachen Buchsen für sog. Bananenstecker realisiert werden.

Außerdem kann das elektrische Modifizierungssystem eine Schaltung aufweisen, welche eingerichtet ist zum Emulieren einer Strommessspule, insbesondere einer Rogowski Spule. Dazu kann die Schaltung eine solche in geeigneter Weise dimensionierte Strommessspule aufweisen, durch welche der Strom geführt wird, welcher an einer ersten Anschlussklemme des Eingangs-Stromanschlusses in die beschriebene Adaptervorrichtung eingespeist und an einer zweiten Anschlussklemme des Eingangs-Stromanschlusses aus der beschriebenen Vorrichtung wieder herausgeführt wird.

Bei bevorzugten Ausführungsformen weist die Adapter-vorrichtung selbst eine solche Strommessspule auf. Diese kann direkt auf einer Leiterplatte ausgebildet sein, wobei auf der Oberfläche der Leiterplatte ausgebildete Leiterbahnen verwendet werden können.

G Alternativ oder zusätzlich weist das elektrische Modifizierungssystem eine Schaltung auf, welche eingerichtet ist, einen Strom-Signalumformer, insbesondere einen Niedrig-Leistung Strom-Signalumformer, zu emulieren.

Ein solcher Strom-Signalumformer kann durch einen geeignet dimensionierten Transformator emuliert werden, welcher eine elektrische Komponente der beschriebenen Vorrichtung darstellen kann. Ein Niedrig-Leistung Strom-Signalumformer (low power current transducer) kann durch einen sog. Niedrig-Leistung Strom-Transformer (low power current transformer) emuliert werden.

Genauso wie die vorstehend beschriebene Strommessspule kann auch der Strom-Signalumformer zwischen die beiden vorstehend beschriebenen Anschlussklemmen des Eingangs-Stromanschlusses geschaltet sein. Falls neben dem Strom-Signalumformer auch die vorstehend genannte Strommessspule verwendet wird, dann ist es vorteilhaft, wenn die beiden Komponenten Strommessspule und Strom-Signalumformer hintereinander (zwischen die beiden Anschlussklemmen) geschaltet sind.

Der beschriebenen Vorrichtung liegt die Erkenntnis zugrunde, dass der Anwendungsbereich eines Testgenerators, welcher für herkömmliche (erste) Schutzeinrichtungen konzipiert ist, durch die Verwendung der Vorrichtung als eine Art Adapter dahingehend erweitert werden kann, dass auch (zweite) Schutzeinrichtungen bzw. Kleinsignal-Schutzeinrichtungen getestet werden können, welche für einen Testvorgang ganz andere (zweite) Testsignale bzw. Test-Kleinmesssignale benötigen, die eine elektrische unterschiedliche Charakteristik haben. Anders ausgedrückt stellt die beschriebene Vorrichtung einen Wandler dar, welcher eine elektrische Transferfunktion aufweist bzw. welcher durch eine solche Transferfunktion gekennzeichnet ist, die für eine Anpassung der "elektrischen Charakteristik" des Testgenerators an die zweite Schutzeinrichtung bzw. an deren Schutzelektronik sorgt. Der Begriff "elektrische Charakteristik" umfasst dabei alle Parameter, welche von einer elektrischen Transferfunktion beschrieben bzw. welche von einem Wandler mit einer solchen elektrischen Transferfunktion verändert werden können. In diesem Zusammenhang kann unter dem Begriff der "elektrischen Charakteristik" nicht lediglich die Stärke des Test-Messsignals (Spannungshöhe und/oder Stromstärke) verstanden werden. Vielmehr kann auch die Stärke des Ausgangs, beispielsweise dessen Impedanz, welcher das jeweilige Signal bereitstellt, die elektrische Charakteristik mitbestimmen. Außerdem kann eine Anpassung der "elektrischen Charakteristik" beispielsweise eine Anpassung einer differentiellen bzw. differenzierenden Eigenschaft eines Wandlers darstellen.

In anderen Worten ausgedrückt kann man sagen, dass mit der beschriebenen Vorrichtung, welche nachfolgend in diesem Dokument auch als Adaptervorrichtung bezeichnet wird, eine Kompensation einer Fehlanpassung durchgeführt werden kann, welche darauf beruht, dass sich die Transferfunktionen von unterschiedlichen Wandler-Technologien untereinander deutlich unterscheiden.

Der Anwendungsbereich eines Test-Generators kann dadurch erweitert werden, dass bei Bedarf die beschriebene Adaptervorrichtung, welche den vorstehend erwähnten Adapter darstellt, zwischen den Test-Generator und der zweiten Schutzeinrichtung geschalten wird. Falls der Test-Generator für eine einleitend beschriebene und seit langem bekannte Schutzeinrichtung konzipiert ist und es sich bei der zweiten Schutzeinrichtung um eine einleitend beschriebene Kleinsignal-Schutzeinrichtung handelt, dann sorgt die beschriebene Vorrichtung als ein Adapter für eine geeignete Modifikation des Test-Messsignales zu einem Test-Kleinmesssignal. Falls später (wieder) eine herkömmliche Schutzeinrichtung ("Nicht-Kleinsignal-Schutzeinrichtung") getestet werden soll, dann kann die beschriebene Adaptervorrichtung einfach wieder herausgenommen und der Test-Generator direkt mit der Schutzeinrichtung gekoppelt werden.

Der Test-Generator kann ein Funktionsgenerator sein, welcher verschiedene zeitliche Verläufe von Spannungs- und/oder Stromsignalen bereitstellt, welche die ersten Test-Messsignale darstellen. Die zeitlichen Verläufe, welche nachfolgend auch als Routinen bezeichnet werden, können mittels einer Datenverarbeitungseinrichtung, beispielsweise ein herkömmlicher PC, über eine geeignete Datenschnittstelle an den Test-Generator übertragen werden.

Die Ausgangsschnittstelle kann bei bevorzugten Ausführungsbeispielen eine Buchse bzw. eine Kupplung für einen Datenstecker, beispielsweise ein sog. RJ 45 Stecker, aufweisen. Standardisierte Steckverbindungen ermöglichen auf vorteilhafte Weise eine einfache und zuverlässige Weitergabe der zweiten Test-Messsignale. Es wird darauf hingewiesen, dass Datenschnittstellen bei fast allen Anwendungen der beschriebenen Vorrichtung hinsichtlich ihrer Dimensionierung für Spannungs- und Strompegel völlig ausreichend sind, da lediglich sog. Kleinsignalwandler emuliert werden. Daher sind die zweiten Test-Messsignale sog. Kleinsignale, die sowohl hinsichtlich ihrer Spannung als auch hinsichtlich ihrer Stromstärke ausreichend klein sind, so dass sie von bekannten Datenschnittstellen fehlerfrei übertragen werden können. s

Gemäß einem Ausführungsbeispiel der Erfindung ist das elektrische Modifizierungssystem eingerichtet zum Modifizieren einer elektrischen Transferfunktion, insbesondere zum Vornehmen einer Impedanzanpassung und/oder einer differenziellen Charakteristik.

Beispielsweise weist die Ausgangsschnittstelle (für einen Eingang einer angeschlossenen zweiten Schutzeinrichtung) eine passende Impedanz auf, welche unterschiedlich ist zu der Impedanz eines Ausgangs des (an die Eingangsschnittstelle angeschlossenen) Testgenerators.

Gemäß einem weiteren Ausführungsbeispiel der Erfindung weist das zweite Test-Messsignal eine Spannung von weniger als 20V, insbesondere weniger als 10V, weiter insbesondere weniger als 5V, weiter insbesondere weniger als 1V, weiter insbesondere weniger als 100mV, weiter insbesondere weniger als 10mV, weiter insbesondere weniger als 1mV, und noch weiter insbesondere weniger als 100µV auf. Alternativ oder in Kombination weist das Test-Messsignal einen Strom von weniger als 20mA, insbesondere weniger als 10mA, insbesondere weniger als 5mA, insbesondere weniger als 1mA, insbesondere weniger als 100µA, und weiter insbesondere weniger als 10µA auf.

Die beschriebene Adaptervorrichtung kann damit zum Emulieren von sog. Kleinsignalwandlern verwendet werden, welche zukünftig zunehmend verwendet werden können anstelle der derzeit noch am meisten verbreiteten Transformatoren zum Reduzieren der Signalpegel von Stromnetz-Messgeräten.

Die beschriebene Adaptervorrichtung kann ferner einen Auswahlschalter aufweisen, mittels welchem ausgewählt werden kann, ob ein Ausgangssignal der Strommessspule und oder ein Ausgangssignal des Strom-Signalumformer an die Ausgangsschnittstelle weitergeleitet wird. Zwischen einem solchen Schalter und der jeweiligen Komponente Stromessspule und Strom-Signalumformer können geeignete elektrische Verstärkungseinrichtungen, beispielsweise Operationsverstärker, vorgesehen sein, um die betreffenden Ausgangssignale in geeigneter Weise zu verstärken.

Gemäß einem weiteren Ausführungsbeispiel der Erfindung weist die Eingangsschnittstelle einen Eingangs-Spannungsanschluss auf. Alternativ oder in Kombination weist die Ausgangsschnittstelle einen Ausgangs-Spannungsanschluss auf.

Auch der Eingangs-Spannungsanschluss umfasst bevorzugt zumindest zwei Anschlussklemmen, welche mit einfachen Buchsen für sog. Bananenstecker realisiert werden können. Eine der beiden Anschlussklemmen kann mit Masse bzw. einem Erdungspotential verbunden sein.

Gemäß einem weiteren Ausführungsbeispiel der Erfindung weist das elektrische Modifizierungssystem eine Schaltung zum Emulieren eines Elektrische Feld Sensors auf.

In der Hochspannungstechnik verwendete Elektrische Feld Sensoren arbeiten häufig wie ein Kondensator, welcher in das zu messende elektrische Feld eingebracht und dabei aufgeladen wird. Durch eine Integration des entsprechenden Aufladungsstromes ergibt sich dann ein Wert, welcher für die Stärke des elektrischen Feldes indikativ ist.

Zur Emulation eines Elektrische Feld Sensor (electric field probe) kann ein einfacher Kondensator verwendet werden, welcher zwischen einer Anschlussklemme des Eingangs-Spannungsanschlusses geschalten ist.

Gemäß einem weiteren Ausführungsbeispiel der Erfindung weist die Schaltung die Schaltung zum Emulieren des Elektrische Feld Sensors auf (a) eine Kondensator-Anordnung, welche zumindest zwei Kondensatoren umfasst; und (b) eine Kondensator-Auswahleinheit, welche in Serie mit der Kondensator-Anordnung zwischen der Eingangsschnittstelle und der Ausgangsschnittstelle geschalten ist. Die Kondensator-Auswahleinheit ist eingerichtet, durch eine gezielte Aktivierung bzw. Deaktivierung eines Kondensators die effektive Kapazität der Kondensator-Anordnung zwischen der Eingangsschnittstelle und der Ausgangsschnittstelle zu verändern.

Durch die beschriebene Kombination aus in geeigneter Weise miteinander verschalteter Kondensator-Anordnung und Kondensator-Auswahleinheit können verschiedene Elektrische Feld Sensoren emuliert werden. Dadurch wird die Flexibilität der beschriebenen Adaptervorrichtung erhöht.

Die Kondensator-Auswahleinheit kann mittels eines Auswahlschalters oder, sofern eine Änderung der Kapazität nicht sehr häufig vorgenommen werden soll, auch durch eine Verdrahtungs-Modifizierungseinheit, beispielsweise ein sog. Jumper, vorgenommen werden.

Gemäß einem weiteren Ausführungsbeispiel der Erfindung weist die Schaltung zum Emulieren des Elektrische Feld Sensors ferner eine weitere Kondensator-Anordnung auf, welche eingangsseitig mit einer Anschlussklemme des Eingangs-Spannungsanschlusses verbunden ist und welche ausgangsseitig mit einem weiteren Eingangs-Spannungsanschluss einer weiteren Vorrichtung verbindbar ist.

Mit der beschriebenen weiteren Kondensator-Anordnung kann ein Übersprechen eines Elektrische Feld Sensors zwischen verschiedenen Phasen eines Stromnetzes emuliert werden, welches zwar nicht gewünscht ist, welches in der Praxis aber trotzdem vorkommt.

Auch die weitere Kondensator-Anordnung kann mehrere (weitere) Kondensatoren sowie eine weitere Kondensator-Auswahleinheit aufweisen, so dass für die Kondensator-Anordnung unterschiedliche effektive Kapazitäten bereitgestellt werden können. Damit kann ein Übersprechen bei einer Elektrische Feld Messung in unterschiedlicher Stärke emuliert werden.

Gemäß einem weiteren Ausführungsbeispiel der Erfindung weist das elektrische Modifizierungssystem eine Schaltung zum Emulieren eines Spannung-Signalumformers auf, insbesondere zum Emulieren eines Niedrig-Leistung Spannung-Signalumformers.

Die Emulation des Spannung-Signalumformers und insbesondere des Niedrig-Leistung Spannung-Signalumformer (low power voltage transducer) kann insbesondere mittels eines Spannungsteilers der beschriebenen Adaptervorrichtung realisiert werden, welcher zwischen zwei Anschlussklemmen des Eingangs-Spannungsanschlusses geschalten ist. Ein Knoten zwischen zwei Widerständen des Spannungsteilers ist dann mit der Ausgangsschnittstelle verbunden.

Gemäß einem weiteren Ausführungsbeispiel der Erfindung weist die Vorrichtung ferner auf eine Temperatursensor-Emulationsschaltung, welche eingerichtet ist, ein emuliertes Test-Temperaturmesssignal zu generieren und an die Ausgangsschnittstelle zu übermitteln, wobei eine elektrische Ausgangscharakteristik der Temperaursensor-Emulationsschaltung der elektrischen Ausgangscharakteristik einer realen Temperatur-Messeinrichtung nachgebildet ist.

Die beschriebene Temperaursensor-Emulationsschaltung kann also ein Signal eines realen Temperatursensors nachbilden, welcher bei manchen Schutzschalter-Messsystemen vorhanden ist, um die Temperatur an der betreffenden Messstelle des Stromnetzes zu bestimmen und diese Temperatur bei der Entscheidung zu berücksichtigen, ob der betreffende Schutzschalter ausgelöst werden soll. Damit trägt die beschriebene Temperaursensor-Emulationsschaltung dazu bei, dass die Schutzeinrichtungen noch genauer und unter noch realistischeren Bedingungen getestet werden können.

Die Temperaursensor-Emulationsschaltung kann beispielsweise eine Schaltung mit mehreren Widerständen enthalten, wobei durch einen Auswahlschalter einzelne Widerstände aktiviert werden können, welche dann die elektrische Charakteristik des Test-Temperaturmesssignals mitbestimmen. Die Schaltung kann beispielsweise eine Parallelschaltung sein. Jedem Widerstand kann ein bestimmter Temperaturbereich zugeordnet sein.

Gemäß einem weiteren Ausführungsbeispiel der Erfindung weist die Eingangsschnittstelle ferner auf (a) einen weiteren Eingangs-Stromanschluss, welcher über eine Strom-Verbindungsleitung mit der Ausgangsschnittstelle verbindbar ist, so dass ein Eingangs-Stromsignal direkt an die Ausgangsschnittstelle weitergeleitet wird; und/oder (b) einen weiteren Eingangs-Spannungsanschluss, welcher über eine Spannungs-Verbindungsleitung mit der Ausgangsschnittstelle verbindbar ist, so dass ein Eingangs-Spannungssignal direkt an die Ausgangsschnittstelle weitergeleitet wird.

Eine direkte elektrische Verbindung zwischen dem weiteren Eingangs-Stromanschluss bzw. dem weiteren Eingangs-Spannungsanschluss und der Ausgangsschnittstelle kann durch eine Betätigung eines Auswahlschalters hergestellt werden, welcher sich zwischen dem weiteren Eingangs-Stromanschluss bzw. dem weiteren Eingangs-Spannungsanschluss und der Ausgangsschnittstelle befindet. Durch eine entsprechende Betätigung des Auswahlschalters werden bevorzugt die vorstehend beschriebenen Komponenten des elektrischen Modifizierungssystems und weiter bevorzugt das ganze elektrische Modifizierungssystem aus dem Signalpfad zwischen Eingangsschnittstelle und Ausgangsschnittstelle entfernt.

Eine solche direkte Verbindung zum Durchschleifen von Eingangssignalen kann beispielsweise dann von Nutzen sein, wenn eine herkömmliche Schutzeinrichtung ("Nicht-Kleinsignal-Schutzeinrichtung") getestet werden soll und die beschriebene Adaptervorrichtung zwischen dem Test-Generator und der Schutzeinrichtung belassen (und nicht herausgenommen) werden soll. Es ist dann lediglich erforderlich, dass die von dem Test-Generator erzeugten Test-Messsignale an den weiteren Eingangs-Stromanschluss bzw. den weiteren Eingangs-Spannungsanschluss angeschlossen werden.

Gemäß einem weiteren Aspekt der Erfindung wird beschrieben ein System zum Modifizieren einer Mehrzahl von Test-Messsignalen für Schutzeinrichtungen für elektrische Stromnetze. Das System weist auf eine Mehrzahl von Vorrichtungen der vorstehend beschriebenen Art.

Dem beschriebenen System, welches zumindest zwei vorstehend beschriebene Adaptervorrichtungen aufweist und demzufolge auch als Adaptersystem bezeichnet werden kann, liegt die Erkenntnis zugrunde, dass durch eine geeignete "Parallelisierung" gleichzeitig ein Test bei bzw. mit verschiedenen Phasen eines Stromnetzes durchgeführt werden kann. Jede Adaptervorrichtung kann als ein Kanal des mehrkanaligen Adaptersystems angesehen werden. Jeweils ein Kanal kann einer ausgewählten Kombination aus zwei Phasen zugeordnet sein.

Bevorzugt weist das Adaptersystem drei oder vier Kanäle auf. Mit einem dreikanaligen Adaptersystem kann bei Drehstrom jeweils ein Kanal einer Kombination von zwei ausgewählten Phasen des Drehstroms zugeordnet sein. Bei einem vierkanaligen Adaptersystem kann jeweils ein Kanal einer ausgewählten Kombination von zwei Leitungen aus insgesamt vier Leitungen zugeordnet sein, wobei diese vier Leitungen die drei Phasen sowie dem Nullleiter eines Drehstromnetzes zugeordnet sind.

Gemäß einem weiteren Aspekt der Erfindung wird beschrieben ein Verfahren zum Modifizieren von Test-Messsignalen für Schutzeinrichtungen für elektrische Stromnetze unter Verwendung einer Adaptervorrichtung, insbesondere unter Verwendung einer vorstehend beschriebenen Adaptervorrichtung. Das Verfahren weist auf (a) Zuführen eines ersten Test-Messsignales von einem Test-Generator an eine Eingangsschnittstelle der Adapter-vorrichtung, wobei das erste Test-Messsignal abgestimmt ist auf eine erste elektrische Eingangscharakteristik einer ersten Schutzeinrichtung für ein Stromnetz; (b) Umwandeln des ersten Test-Messsignales in ein zweites Test-Messsignal unter Verwendung eines mit der Eingangsschnittstelle gekoppelten elektrischen Modifizierungssystems, wobei das zweite Test-Messsignal abgestimmt ist auf eine zweite elektrische Eingangscharakteristik einer zweiten Schutzeinrichtung für das Stromnetz; und (c) Ausgeben des zweiten Test-Messsignales an die zweite Schutzeinrichtung über eine Ausgangsschnittstelle der Adaptervorrichtung.

Auch dem beschriebenen Verfahren liegt die Erkenntnis zugrunde, dass der Anwendungsbereich eines Testgenerators durch die Verwendung der Adaptervorrichtung dahingehend erweitert werden kann, dass mit dem Testgenerator unterschiedliche Arten von Schutzeinrichtungen getestet werden können. Bei einer (ersten) Art von Schutzeinrichtungen wird die Adaptervorrichtung nicht benötigt. Bei der (zweiten) anderen Art von Schutzeinrichtungen wird die Adaptervorrichtung bzw. ein Adaptersystem zwischen den Testgenerator und die zu testende Schutzeinrichtung geschaltet.

Weitere Vorteile und Merkmale der vorliegenden Erfindung ergeben sich aus der folgenden beispielhaften Beschreibung derzeit bevorzugter Ausführungsformen.
- Figur 1: zeigt mit ihren Teilfiguren 1A und 1B ein Blockschaltbild eines vierkanaligen Adaptersystems mit vier Adaptervorrichtungen, die jeweils ein elektrisches Modifizierungssystem aufweisen, welches eingangsseitig mit einer Eingangsschnittstelle und ausgangsseitig mit einer Ausgangsschnittstelle verbunden ist.
- Figur 2: zeigt die für eine Emulation einer Strommessspule sowie eines Strom-Signalumformers verwendeten Komponenten des elektrischen Modifizierungssystems.
- Figur 3: zeigt die für eine Emulation eines Elektrische Feld Sensors verwendeten Komponenten des elektrischen Modifizierungssystems.
- Figur 4: zeigt die für eine Emulation eines SpannungSignalumformers verwendeten Komponenten des elektrischen Modifizierungssystems.

Es wird darauf hingewiesen, dass die nachfolgend beschriebenen Ausführungsformen lediglich eine beschränkte Auswahl an möglichen Ausführungsvarianten der Erfindung darstellen.

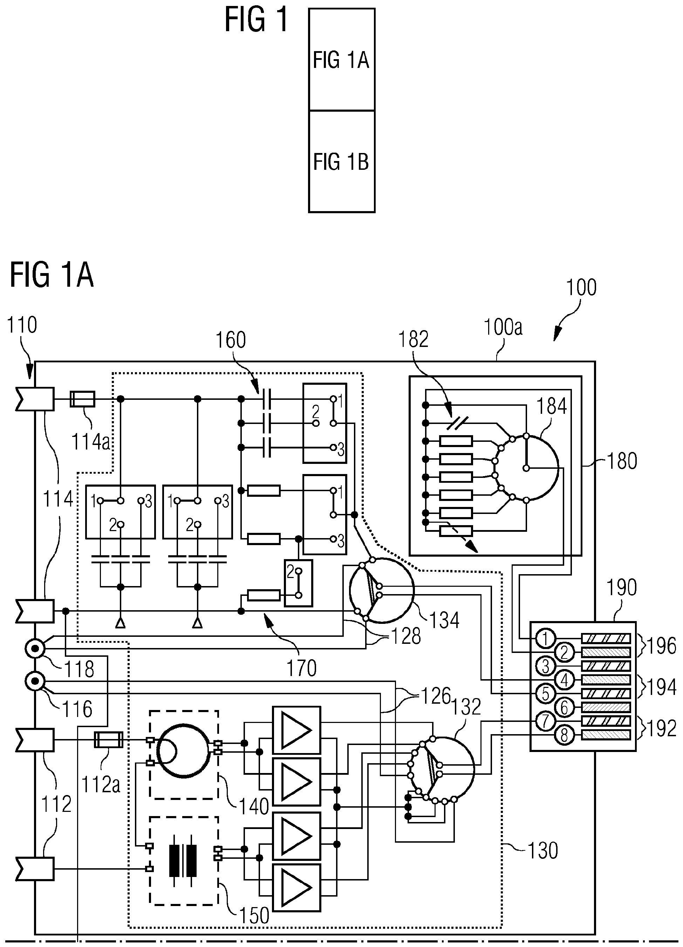

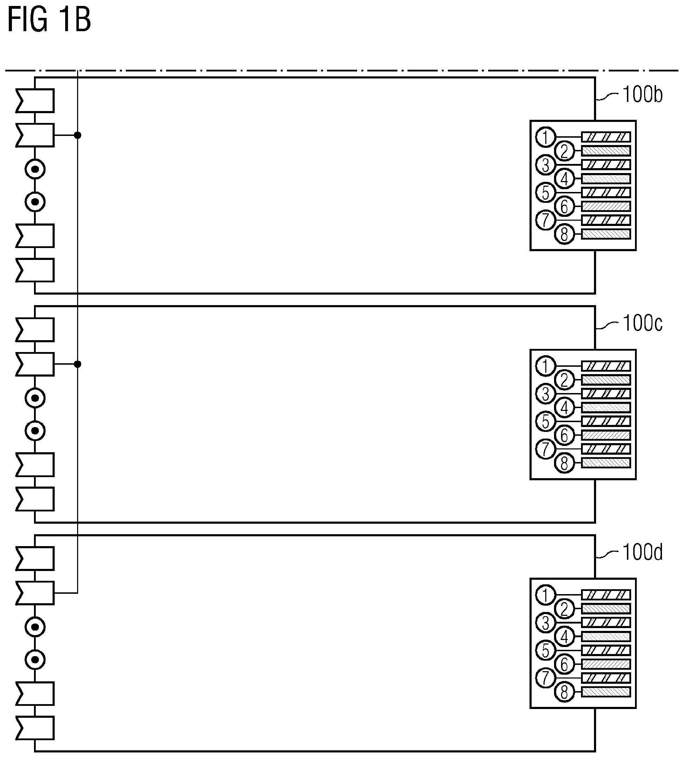

Figur 1 bzw. die Figuren 1A und 1B zeigen ein Blockschaltbild eines vierkanaligen Adaptersystems 100 mit vier Adaptervorrichtungen 100a, 100b, 100c und 100d. Aus Gründen der Übersichtlichkeit der Darstellung ist in Figur 1A lediglich die erste Adaptervorrichtung 100a im Detail dargestellt. Die anderen Adaptervorrichtungen 100b, 100c und 100d, welche identisch aufgebaut sind, sind in Figur 1B lediglich schematisch ohne diejenigen Komponenten gezeigt, welche die nachstehend beschriebenen Funktionalitäten bereitstellen.

Die Adaptervorrichtung 100a weist eine Eingangsschnittstelle 110 auf, an der Test-Messsignale von einem nicht dargestellten Test-Generator zum Testen von Schutzeinrichtungen für elektrische Stromnetze empfangen werden können. An einer Ausgangsschnittstelle 190 werden von der Adaptervorrichtung 100a modifizierte Test-Messsignale an eine nicht dargestellte sog. Kleinsignal-Schutzeinrichtung ausgegeben. Zwischen der Eingangsschnittstelle 110 und der Ausgangsschnittstelle 190 ist ein elektrisches Modifizierungssystem 130 geschaltet, welches für die eigentliche Modifizierung der Test-Messsignale sorgt und welches in Figur 1A durch eine gepunktete Linie umrandet ist.

Die Eingangsschnittstelle 110 weist einen Eingangs-Stromanschluss 112 auf, welcher zwei Anschlussklemmen umfasst. Eine Sicherung 112a, welche einem der beiden Anschlussklemmen nachgeschaltet ist, sorgt für eine Strombegrenzung, um eine Beschädigung von zumindest einigen Komponenten des elektrischen Modifizierungssystems 130 zu verhindern. Ferner weist die Eingangsschnittstelle 110 einen Eingangs-Spannungsanschluss 114 auf, welche ebenfalls zwei Anschlussklemmen umfasst. Eine Sicherung 114a sorgt auch hier für einen Schutz des elektrischen Modifizierungssystems 130. Die insgesamt vier Anschlussklemmen des Eingangs-Stromanschlusses 112 und des Eingangs-Spannungsanschlusses 114 sind gemäß dem hier dargestellten Ausführungsbeispiel als Buchsen ausgebildet, in die sog. Bananenstecker eingesteckt werden können.

Wie aus Figur 1A ersichtlich, weist die Eingangsschnittstelle 110 ferner einen weiteren Eingangs-Stromanschluss 116 sowie einen weiteren Eingangs-Spannungsanschluss 118 auf. Diese Anschlüsse 116 und 118, welche gemäß dem hier dargestellten Ausführungsbeispiel mittels so genannter BNC Buchsen realisiert sind, dienen dazu, eingangsseitig empfangene Test-Messsignalen ohne eine Modifikation durch das elektrische Modifizierungssystem 130 zu der Ausgangsschnittstelle 190 durch zu schleifen. Für Stromsignale ist dafür eine Strom-Verbindungsleitung 126 vorgesehen, welche über einen nachfolgend noch genauer beschriebenen Strom-Auswahlschalter 132 ein entsprechendes Test-Messsignal von dem weiteren Eingangs-Stromanschluss 116 an einen Ausgangs-Stromanschluss 192 der Ausgang Schnittstelle 190 (ohne eine Modifikation des Test-Messsignales) weiterleiten kann. In entsprechender Weise ist für eingehende Spannungssignale eine Spannungs-Verbindungsleitung 128 vorgesehen, welche über einen nachfolgend noch genauer beschriebenen Spannung-Auswahlschalter 134 ein entsprechendes Test-Messsignal von dem weiteren Eingangs-Spannungsanschluss 114 an einen Ausgangs-Spannungsanschluss 194 der Ausgang Schnittstelle 190 (ohne eine Signalmodifikation) weiterleiten kann.

Bevor nachstehend die Struktur und die Funktionsweise des elektrischen Modifizierungssystems 130 im Detail erläutert werden, soll noch kurz auf eine optionale Funktionalität der Adaptervorrichtung 100a eingegangen werden. Die in Figur 1A dargestellte Adaptervorrichtung 100a weist nämlich eine Temperatursensor-Emulationsschaltung 180 auf, mittels welcher ein Messsignal eines realen Temperatursensors nachgebildet werden kann, welcher bei manchen Schutzschalter-Messsystemen vorhanden ist, um die Temperatur an der betreffenden Messstelle des Stromnetzes zu bestimmen. Gemäß dem hier dargestellten Ausführungsbeispiel wird mit der Temperatursensor-Emulationsschaltung 180 ein Platin-Messwiderstand als Temperatursensor nachgebildet.

Wie aus Figur 1A ersichtlich, weist die Temperatursensor-Emulationsschaltung 180 eine Widerstandsmatrix 182 umfassend eine Mehrzahl von parallel geschalteten Widerständen auf. Mittels eines Auswahlschalters 184 kann jeweils einer dieser Widerstände ausgewählt werden, so dass er zwischen zwei Anschlussklemmen eines Ausgangsanschlusses 196 für Test-Temperaturmesssignale geschalten ist, wobei dieser Ausgangsanschluss 196 in die Ausgangsschnittstelle 190 integriert ist. Jedem der Widerstände der Widerstandsmatrix 182 ist ein bestimmter Temperaturbereich zugeordnet, so dass durch eine geeignete Betätigung des Auswahlschalters 184 ein Temperatursensor mit einem bestimmten Temperaturmessbereich ausgewählt werden kann. Die Widerstände der Widerstandsmatrix 182 können feste Widerstände sein. Alternativ können auch variable Widerstände verwendet werden, wie in Figur 1A für den untersten Widerstand der Widerstandsmatrix 182 gezeigt.

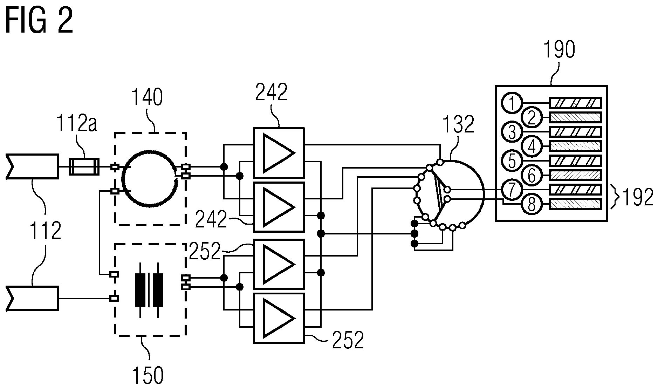

In Folgenden werden die Struktur und die Funktionsweise des elektrischen Modifizierungssystems 130 näher beschrieben. Wie aus Figur 1A ersichtlich, weist das elektrische Modifizierungssystem 130 eine als eine Rogowski Spule ausgebildete Strommessspule 140 auf, mittels welcher die elektrische Charakteristik einer realen Messspule, insbesondere einer realen Rogowski Spule emuliert wird, so wie sie beim Einsatz an einer Messstelle eines elektrischen Stromnetzes zum Einsatz kommt. Ferner weist das elektrische Modifizierungssystem 130 noch einen Strom-Signalumformer 150 auf, welcher einen entsprechenden Strom-Signalumformer eines realen Messsystems für elektrische Stromnetze emuliert. Da die beiden Komponenten Strommessspule 140 und Strom-Signalumformer 150 die elektrische Charakteristik von elektrischen Strömen modifizieren, sind diese eingangsseitig mit dem Eingangs-Stromanschluss 112 der Eingangsschnittstelle 110 verbunden. Ausgangsseitig sind diese beiden Komponenten mit dem Ausgangs-Stromanschluss 192 der Ausgangsschnittstelle 190 verbunden, wobei durch den bereits vorstehend erwähnten Strom-Auswahlschalter 132 ausgewählt werden kann, ob die elektrische Charakteristik des Ausgangs-Stromanschlusses 192 durch die Strommessspule 140 oder durch den Strom-Signalumformer 150 bestimmt wird. Die als Rogowski Spule ausgebildete Strommessspule 140 und der Strom-Signalumformer 150 sowie deren Funktionen werden weiter nachstehend anhand von Figur 2 im Detail erläutert.

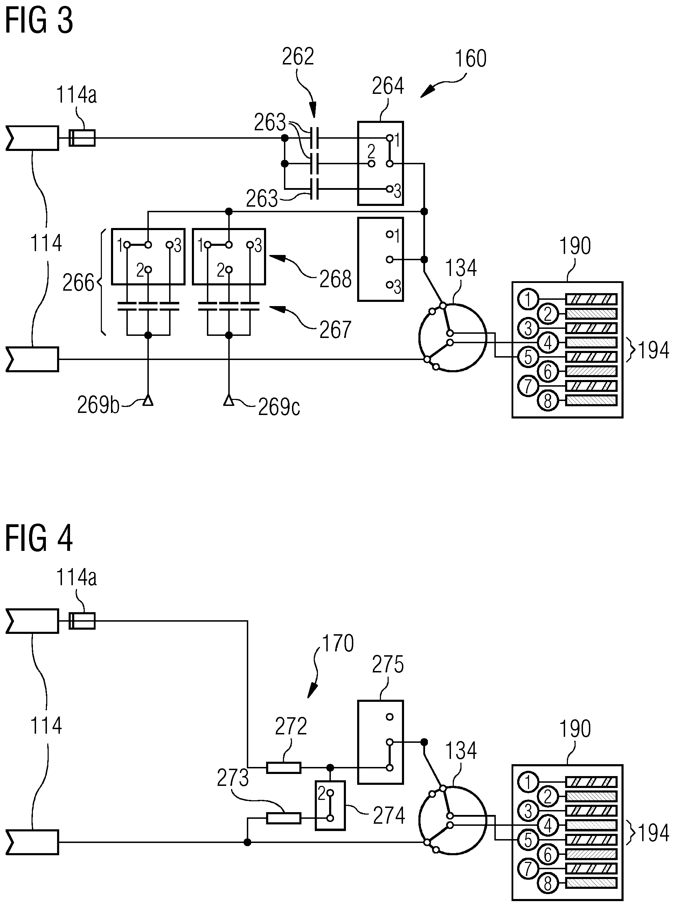

Ferner ist aus Figur 1A ersichtlich, dass das elektrische Modifizierungssystem 130 noch zwei Funktionseinheiten umfasst, welche die elektrische Charakteristik des Ausgangs-Spannungsanschlusses 194 der Ausgangsschnittstelle 190 bestimmen. Diese Funktionseinheiten sind zum einen eine Schaltung 160 zum Emulieren eines Elektrische Feld Sensors und zum anderen eine als ein Spannungsteiler ausgebildete Schaltung 170 zum Emulieren eines Spannung-Signalumformers. Mittels des vorstehend erwähnten Spannung-Auswahlschalters 134 kann eingestellt werden, welche dieser beiden Funktionseinheiten zwischen den Eingangs-Spannungsanschluss 114 und den Ausgangs-Spannungsanschluss 194 elektrisch aktiv geschalten werden soll. Die Schaltung 160 und die Schaltung 170 sowie deren Funktionen werden weiter nachstehend anhand von Figur 3 bzw. Figur 4 im Detail erläutert.

Figur 2 zeigt die Strommessspule 140 sowie den Strom-Signalumformer 150, welche zueinander in Reihe zwischen die beiden Anschlussklemmen des Eingangs-Stromanschlusses 112 geschalten sind. Dies bedeutet, dass ein entsprechender Eingangsstrom sowohl durch die Stromessspule 140 als auch (in gleicher Höhe) durch den Strom-Signalumformer 150 fließt. Gemäß dem hier dargestellten Ausführungsbeispiel ist die Strommesserspule 140 eine miniaturisierte Spule, die auf einer nicht dargestellten Leiterplatte aufgebaut ist und eine Rogowski Spule emuliert. Ein Signalausgang der Stromessspule 140 ist mit einer Verstärkerschaltung 242 verbunden, welcher die Ausgabesignale der Strommessspule 140 verstärkt und ausgewählten Eingängen des Strom-Auswahlschalters 132 zuführt. In entsprechender Weise werden die Ausgabesignale des Strom-Signalumformers 150 einer Verstärkerschaltung 252 zugeführt. Die entsprechend verstärkten Signale werden dann an andere ausgewählte Eingänge des Strom-Auswahlschalters 132 übergeben. Mittels des Strom-Auswahlschalters 132 kann dann eingestellt werden, ob die Ausgabesignale der Strommessstelle 140 oder die Ausgangssignale des Strom-Signalumformers 150 an den Ausgangs-Stromanschluss 192 der Ausgangsschnittstelle 190 übergeben werden. Es wird darauf hingewiesen, dass der Strom-Auswahlschalter 132 auch so eingestellt werden kann, dass anstelle dieser beiden Ausgangssignale auch ein Signal, welches an dem in Figur 1A dargestellten weiteren Eingangs-Stromanschluss 116 eingespeist wird, ohne eine Modifikation an dem Ausgangs-Stromanschluss 192 ausgegeben werden kann.

Figur 3 zeigt in einer vergrößerten Darstellung die für eine Emulation eines Elektrische Feld Sensors verwendete Schaltung 160 des elektrischen Modifizierungssystems 130. Gemäß dem hier dargestellten Ausführungsbeispiel wird dazu eine Kondensator-Anordnung 262 verwendet, welche drei parallel geschaltete Kondensatoren 263 umfasst. Eingangsseitig sind diese Kondensatoren 263 (über die Sicherung 114a) mit einer Anschlussklemme des Eingangs-Spannungsanschlusses 114 verbunden. Ausgangsseitig sorgt eine als ein so genannter Jumper ausgebildete Kondensator-Auswahleinheit 264 dafür, dass ein ausgewählter der drei Kondensatoren 263 zwischen die die betreffende Anschlussklemme des Eingangs-Spannungsanschlusses 114 und den Spannung-Auswahlschalter 134 geschalten ist.

Gemäß dem hier dargestellten Ausführungsbeispiel weist die Schaltung 160 ferner eine weitere Kondensatoranordnung 266 auf, welche ebenfalls (parallel zu der Kondensatoranordnung 262) mit dem Spannung-Auswahlschalter 134 verbunden ist. Mit dieser weiteren Kondensatoranordnung 266 kann ein Übersprechen eines Messsignals eines Elektrische Feld Sensors zwischen verschiedenen Phasen eines Stromnetzes emuliert werden. Die weitere Kondensatoranordnung 266 umfasst dafür zwei ebenfalls als sog. Jumper ausgebildete Kondensator-Auswahleinheiten 268, denen jeweils drei von insgesamt sechs Kondensatoren 267 zugeordnet sind. Jeweils eine der beiden Kondensator-Auswahleinheiten 268 und die drei dazugehörigen Kondensatoren 267 simulieren ein Übersprechen zu einer bestimmten anderen Phase des Stromnetzes, indem sie mit einer Anschlussklemme des Eingangs-Spannungsanschlusses einer anderen Adaptervorrichtung verbunden sind. Gemäß dem hier dargestellten Ausführungsbeispiel ist die Anschlussklemme 269b dem Eingangs-Spannungsanschluss (114) der Adaptervorrichtung 100b zugeordnet und die die Anschlussklemme 269c ist dem Eingangs-Spannungsanschluss (114) der Adaptervorrichtung 100c zugeordnet.

Figur 4 zeigt die für eine Emulation eines Spannung-Signalumformers verwendeten Komponenten des elektrischen Modifizierungssystems 130. Gemäß dem hier beschriebenen Ausführungsbeispiel erfolgt diese Emulation im Wesentlichen durch einen Spannungsteiler, welcher zwei Widerstände 272 und 273 umfasst. Durch eine geeignete Verdrahtung, hergestellt in zwei als Jumper ausgebildeten Verdrahtungs-Modifizierungseinheiten 274 und 275, wird sichergestellt, dass die "geteilte Spannung", welche zwischen den beiden Widerständen 272 und 273 abgegriffen wird, an einem Eingang des Spannung-Auswahlschalters 134 anliegt. Diese Spannung wird, bei einer entsprechenden Schalterstellung des Spannung-Auswahlschalters 134, an den Ausgangs-Spannungsanschluss 194 der Ausgang Schnittstelle 190 übergeben.

### Bezugszeichenliste

- 100: Adaptersystem
- 100a/b/c: Adaptervorrichtung
- 110: Eingangsschnittstelle
- 112: Eingangs-Stromanschluss
- 112a: Sicherung
- 114: Eingangs-Spannungsanschluss
- 114a: Sicherung
- 116: weitere Eingangs-Stromanschluss
- 118: weiteren Eingangs-Spannungsanschluss
- 126: Strom-Verbindungsleitung
- 128: Spannungs-Verbindungsleitung
- 130: elektrisches Modifizierungssystem
- 132: Strom-Auswahlschalter
- 134: Spannung-Auswahlschalter
- 140: Strommessspule / Rogowski Spule
- 150: Strom-Signalumformer
- 160: Schaltung zum Emulieren eines Elektrische Feld Sensors
- 170: Schaltung / Spannungsteiler zum Emulieren eines Spannung-Signalumformers
- 180: Temperatursensor-Emulationsschaltung
- 182: Widerstandsmatrix
- 184: Auswahlschalter
- 190: Ausgangsschnittstelle
- 192: Ausgangs-Stromanschluss
- 194: Ausgangs-Spannungsanschluss
- 196: Ausgangsanschluss für Test-Temperaturmesssignal

- 242: Verstärkerschaltung für Strommessspule Ausgabesignal
- 252: Verstärkerschaltung für Strom-Signalumformer Ausgabesignal
- 262: Kondensator-Anordnung
- 263: Kondensatoren
- 264: Kondensator-Auswahleinheit
- 266: weitere Kondensator-Anordnung
- 267: Kondensatoren
- 268: Kondensator-Auswahleinheit
- 269b/c: Anschlussklemmen für Eingangs-Spannungsanschlüsse der Adaptervorrichtungen 100b bzw. 100c
- 272: Widerstand von Spannungsteiler
- 273: Widerstand von Spannungsteiler
- 274: Verdrahtungs-Modifizierungseinheit / Jumper
- 275: Verdrahtungs-Modifizierungseinheit / Jumper

## Patentansprüche

1. Vorrichtung (100a) zum Modifizieren von Test-Messsignalen für Schutzeinrichtungen für elektrische Stromnetze, die Vorrichtung (100a) aufweisend
eine Eingangsschnittstelle (110) zum Empfangen eines ersten Test-Messsignales von einem Test-Generator, wobei das erste Test-Messsignal abgestimmt ist auf eine erste elektrische Eingangscharakteristik einer ersten Schutzeinrichtung für ein Stromnetz;
ein mit der Eingangsschnittstelle (110) gekoppeltes elektrisches Modifizierungssystem (130) zum Umwandeln des ersten Test-Messsignales in ein zweites Test-Messsignal, wobei
das zweite Test-Messsignal abgestimmt ist auf eine zweite elektrische Eingangscharakteristik einer zweiten Schutzeinrichtung für das Stromnetz; und
eine Ausgangsschnittstelle (190) zum Ausgeben des zweiten Test-Messsignales an die zweite Schutzeinrichtung,
**dadurch gekennzeichnet, dass** die Eingangsschnittstelle (110) einen Eingangs-Stromanschluss (112) aufweist und/oder die Ausgangsschnittstelle (190) einen Ausgangs-Stromanschluss (192) aufweist, wobei das elektrische Modifizierungssystem (130) eine Schaltung (160) aufweist, welche eingerichtet ist, eine Strommessspule, insbesondere eine Rogowski Spule, zu emulieren und/oder das elektrische Modifizierungssystem (130) eine Schaltung (150) aufweist, welche eingerichtet ist, einen Strom-Signalumformer, insbesondere einen Niedrig-Leistung Strom-Signalumformer, zu emulieren.

2. Vorrichtung (100a) gemäß dem vorangehenden Anspruch, wobei das elektrische Modifizierungssystem (130) eingerichtet ist zum Modifizieren einer elektrischen Transferfunktion.

3. Vorrichtung (100a) gemäß einem der vorangehenden Ansprüche, wobei
das zweite Test-Messsignal
eine Spannung von weniger als 20V, insbesondere weniger als 10V, weiter insbesondere weniger als 5V, weiter insbesondere weniger als 1V, weiter insbesondere weniger als 100mV, weiter insbesondere weniger als 10mV, weiter insbesondere weniger als 1mV, und noch weiter insbesondere weniger als 100µV aufweist und/oder
einen Strom von weniger als 20mA, insbesondere weniger als 10mA, insbesondere weniger als 5mA, insbesondere weniger als 1mA, insbesondere weniger als 100µA, und weiter insbesondere weniger als 10µA aufweist.

4. Vorrichtung (100a) gemäß einem der vorangehenden Ansprüche, wobei
die Eingangsschnittstelle (110) einen Eingangs-Spannungsanschluss (114) aufweist und/oder
die Ausgangsschnittstelle (190) einen Ausgangs-Spannungsanschluss (194) aufweist.

5. Vorrichtung (100a) gemäß dem vorangehenden Anspruch, wobei das elektrische Modifizierungssystem (130) eine Schaltung (160) zum Emulieren eines Elektrische Feld Sensors aufweist.

6. Vorrichtung (100a) gemäß dem vorangehenden Anspruch, wobei die Schaltung (160) zum Emulieren des Elektrische Feld Sensors aufweist
eine Kondensator-Anordnung (262), welche zumindest zwei Kondensatoren (263) umfasst; und
eine Kondensator-Auswahleinheit (264), welche in Serie mit der Kondensator-Anordnung (262) zwischen der Eingangsschnittstelle (110) und der Ausgangsschnittstelle (190) geschalten ist; wobei
die Kondensator-Auswahleinheit (264) eingerichtet ist, durch eine gezielte Aktivierung bzw. Deaktivierung eines Kondensators (263) die effektive Kapazität der Kondensator-Anordnung (262) zwischen der Eingangsschnittstelle (110) und der Ausgangsschnittstelle (190) zu verändern.

7. Vorrichtung (100a) gemäß dem vorangehenden Anspruch, wobei die Schaltung (160) zum Emulieren des Elektrische Feld Sensors ferner aufweist
eine weitere Kondensator-Anordnung (266), welche eingangsseitig mit einer Anschlussklemme des Eingangs-Spannungsanschlusses (114) verbunden ist und welche ausgangsseitig mit einem weiteren Eingangs-Spannungsanschluss (269b, 269c) einer weiteren Vorrichtung (100b, 100c) verbindbar ist.

8. Vorrichtung (100a) gemäß einem der drei vorangehenden Ansprüche, wobei
das elektrische Modifizierungssystem (130) eine Schaltung (170) zum Emulieren eines Spannung-Signalumformers aufweist, insbesondere zum Emulieren eines Niedrig-Leistung Spannung-Signalumformers.

9. Vorrichtung (100a) gemäß einem der vorangehenden Ansprüche, ferner aufweisend
eine Temperaursensor-Emulationsschaltung (180), welche eingerichtet ist, ein emuliertes Test-Temperaturmesssignal zu generieren und an die Ausgangsschnittstelle (190) zu übermitteln, wobei eine elektrische Ausgangscharakteristik der Temperaursensor-Emulationsschaltung (180) der elektrischen Ausgangscharakteristik einer realen Temperatur-Messeinrichtung nachgebildet ist.

10. Vorrichtung (100a) gemäß einem der vorangehenden Ansprüche, wobei die Eingangsschnittstelle (110) ferner aufweist
einen weiteren Eingangs-Stromanschluss (116), welcher über eine Strom-Verbindungsleitung (126) mit der Ausgangsschnittstelle (190) verbindbar ist, so dass ein Eingangs-Stromsignal direkt an die Ausgangsschnittstelle (190) weitergeleitet wird; und/oder
einen weiteren Eingangs-Spannungsanschluss (118), welcher über eine Spannungs-Verbindungsleitung (128) mit der Ausgangsschnittstelle (190) verbindbar ist, so dass ein Eingangs-Spannungssignal direkt an die Ausgangsschnittstelle (190) weitergeleitet wird.

11. Ein System (100) zum Modifizieren einer Mehrzahl von Test-Messsignalen für Schutzeinrichtungen für elektrische Stromnetze, das System aufweisend
eine Mehrzahl von Vorrichtungen (100a) gemäß einem der vorangehenden Ansprüche.

12. Verfahren zum Modifizieren von Test-Messsignalen für Schutzeinrichtungen für elektrische Stromnetze unter Verwendung einer Adaptervorrichtung (100a), insbesondere einer Vorrichtung (100a) gemäß einem der vorangehenden Ansprüche 1 bis 10, das Verfahren aufweisend
Zuführen eines ersten Test-Messsignales von einem Test-Generator an eine Eingangsschnittstelle (110) der Adapter-vorrichtung (100a), wobei das erste Test-Messsignal abgestimmt ist auf eine erste elektrische Eingangscharakteristik einer ersten Schutzeinrichtung für ein Stromnetz;
Umwandeln des ersten Test-Messsignales in ein zweites Test-Messsignal unter Verwendung eines mit der Eingangsschnittstelle (110) gekoppelten elektrischen Modifizierungssystems (130), wobei das zweite Test-Messsignal abgestimmt ist auf eine zweite elektrische Eingangscharakteristik einer zweiten Schutzeinrichtung für das Stromnetz; und
Ausgeben des zweiten Test-Messsignales an die zweite Schutzeinrichtung über eine Ausgangsschnittstelle (190) der Adaptervorrichtung (100a).

## Claims

1. Apparatus (100a) for modifying test measurement signals for protective devices for electric power networks, the apparatus (100a) having:
an input interface (110) to receive a first test measurement signal from a test generator, wherein
the first test measurement signal is matched to a first electrical input characteristic of a first protective device for a power network;
an electrical modification system (130) coupled to the input interface (110) to convert the first test measurement signal into a second test measurement signal, wherein
the second test measurement signal is matched to a second electrical input characteristic of a second protective device for the power network; and
an output interface (190) to output the second test measurement signal to the second protective device, **characterized in that** the input interface (110) has an input current connection (112) and/or the output interface (190) has an output current connection (192) wherein the electrical modification system (130) has a circuit (160) which is configured to emulate a current-measuring coil, in particular a Rogowski coil, and/or the electrical modification system (130) has a circuit (150) which is configured to emulate a current transducer, in particular a low power current transducer.

2. Apparatus (100a) according to the preceding claim, wherein
the electrical modification system (130) is configured to modify an electrical transfer function.

3. Apparatus (100a) according to one of the preceding claims, wherein
the second test measurement signal has:
a voltage of less than 20V, particularly less than 10V, more particularly less than 5V, more particularly less than 1V, more particularly less than 100mV, more particularly less than 10mV, more particularly less than 1mV, and even more particularly less than 100µV, and/or
a current of less than 20mA, particularly less than 10mA, particularly less than 5mA, particularly less than 1mA, particularly less than 100µA, and more particularly less than 10µA.

4. Apparatus (100a) according to one of the preceding claims, wherein
the input interface (110) has an input voltage connection (114) and/or
the output interface (190) has an output voltage connection (194) .

5. Apparatus (100a) according to the preceding claim, wherein
the electrical modification system (130) has a circuit (160) to emulate an electric field probe.

6. Apparatus (100a) according to the preceding claim, wherein
the circuit (160) to emulate the electric field probe has:
a capacitor arrangement (262) which comprises at least two capacitors (263); and
a capacitor selection unit (264) which is connected in series with the capacitor arrangement (262) between the input interface (110) and the output interface (190); wherein
the capacitor selection unit (264) is configured to modify the effective capacitance of the capacitor arrangement (262) between the input interface (110) and the output interface (190) through a targeted activation or deactivation of a capacitor (263).

7. Apparatus (100a) according to the preceding claim, wherein
the circuit (160) to emulate the electric field probe furthermore has:
a further capacitor arrangement (266) which is connected on the input side to a connection terminal of the input voltage connection (114) and which is connectable on the output side to a further input voltage connection (269b, 269c) of a further apparatus (100b, 100c).

8. Apparatus (100a) according to one of the three preceding claims, wherein
the electrical modification system (130) has a circuit (170) to emulate a voltage transducer, in particular to emulate a low power voltage transducer.

9. Apparatus (100a) according to one of the preceding claims, furthermore having:
a temperature sensor emulation circuit (180) which is configured to generate an emulated test temperature measurement signal and transmit it to the output interface (190), wherein an electrical output characteristic of the temperature sensor emulation circuit (180) simulates the electrical output characteristic of a real temperature-measuring device.

10. Apparatus (100a) according to one of the preceding claims, wherein
the input interface (110) furthermore has:
a further input current connection (116) which is connectable via a current connection line (126) to the output interface (190) so that an input current signal is forwarded directly to the output interface (190); and/or
a further input voltage connection (118) which is connectable via a voltage connection line (128) to the output interface (190) so that an input voltage signal is forwarded directly to the output interface (190).

11. System (100) for modifying a plurality of test measurement signals for protective devices for electric power networks, the system having:
a plurality of apparatuses (100a) according to one of the preceding claims.

12. Method for modifying test measurement signals for protective devices for electric power networks using an adapter apparatus (100a), in particular an apparatus (100a) according to one of the preceding Claims 1 to 10, the method entailing:
feeding a first test measurement signal from a test generator to an input interface (110) of the adapter apparatus (100a), wherein the first test measurement signal is matched to a first electrical input characteristic of a first protective device for a power network;
converting the first test measurement signal into a second test measurement signal using an electrical modification system (130) coupled to the input interface (110), wherein the second test measurement signal is matched to a second electrical input characteristic of a second protective device for the power network; and
outputting the second test measurement signal to the second protective device via an output interface (190) of the adapter apparatus (100a).

## Revendications

1. Montage (100a) de modification de signaux de mesure de test pour des dispositifs de protection de réseaux électriques, le montage (100a) comportant
une interface (110 ) d'entrée pour recevoir un premier signal de mesure de test d'un générateur de test, le premier signal de mesure de test étant adapté à une première caractéristique électrique d'entrée d'un premier dispositif de protection d'un réseau ;
un système (130) électrique de modification connecté à l'interface (110) d'entrée pour transformer le premier signal de mesure de test en un deuxième signal de mesure de test, dans lequel
le deuxième signal de mesure de test est accordé à une deuxième caractéristique électrique d'entrée d'un deuxième dispositif de protection du réseau et
une interface (190) de sortie pour envoyer le deuxième signal de mesure de test au deuxième dispositif de protection, **caractérisé en ce que**
l'interface (110) d'entrée a une borne (112) de courant d'entrée et/ou l'interface (190) de sortie a une borne (192) de courant de sortie, le système (130) électrique de modification ayant un circuit (160) conçu pour émuler une bobine de courant, notamment une bobine de Rogowski, et/ou le système (130) électrique de modification a un circuit (150) conçu pour émuler un convertisseur de signal de courant, notamment un convertisseur de signal de courant de basse puissance.

2. Montage (100a) suivant la revendication précédente, dans lequel
le système (130) électrique de modification est conçu pour modifier une fonction de transfert électrique.

3. Montage (100a) suivant l'une des revendications précédentes, dans lequel
le deuxième signal de mesure de test a
une tension de moins de 20 V, notamment de moins de 10 V, notamment encore de moins de 5 V, notamment encore de moins de 1 V, notamment encore de moins de 100 mV, notamment encore de moins de 10 mV, notamment encore de moins de 1 mV, et notamment encore davantage de moins de 100 µV et/ou
un courant de moins de 20 mA, notamment de moins de 10 mA, notamment de moins de 5 mA, notamment de moins de 1 mA, notamment de moins de 100 µA, et notamment encore de moins de 10 µA.

4. Montage (100a) suivant l'une des revendications précédentes, dans lequel
l'interface (110) d'entrée a une borne (114) de tension d'entrée et/ou
l'interface (190) de sortie a une borne (194) de tension de sortie.

5. Montage (100a) suivant la revendication précédente, dans lequel
le système (130) électrique de modification a un circuit (160) d'émulation d'un capteur de champ électrique.

6. Montage (100a) suivant la revendication précédente, dans lequel
le circuit (160) d'émulation du capteur de champ électrique a
un agencement (262) de condensateur, qui comprend au moins deux condensateurs (263) ; et
une unité (264) de sélection de condensateur, qui est montée en série avec l'agencement (262) de condensateur entre l'interface (110) d'entrée et l'interface (190) de sortie ; dans lequel
l'unité (264) de sélection de condensateur est conçue pour, par une activation ou une désactivation ciblée d'un condensateur (263), modifier la capacité effective de l'agencement (262) de condensateur entre l'interface (110) d'entrée et l'interface (190) de sortie.

7. Montage (100a) suivant la revendication précédente, dans lequel
le circuit (160) d'émulation du capteur de champ électrique comprend, en outre
un autre agencement (266) de condensateur, qui est relié du côté de l'entrée à une borne de connexion de la borne (114) de tension d'entrée et qui peut être relié du côté de la sortie à une autre borne (269b, 269c) de tension d'entrée d'un autre montage (100b, 100c).

8. Montage (100a) suivant l'une des trois revendications précédentes, dans lequel
le système (130) électrique de modification a un circuit (170) d'émulation d'un convertisseur de signal de tension, notamment d'émulation d'un convertisseur de signal de tension de basse puissance.

9. Montage (100a) suivant l'une des revendications précédentes, comportant, en outre
un circuit (180) d'émulation de capteur de température, qui est conçu pour créer un signal de mesure de température de test émulé et le transmettre à l'interface (190 ) de sortie, une caractéristique électrique de sortie du circuit (180) d'émulation de capteur de température reproduisant la caractéristique électrique de sortie d'un dispositif réel de mesure de la température.

10. Montage (100a) suivant l'une des revendications précédentes, dans lequel l'interface (110) d'entrée a, en outre
une autre borne (116) de courant d'entrée, qui peut être reliée à l'interface (190) de sortie par une ligne (126) de liaison de courant, de manière à acheminer le signal de courant d'entrée directement à l'interface (190) de sortie ; et/ou
une autre borne (118) de tension d'entrée, qui peut être reliée à l'interface (190) de sortie par une ligne (128) de liaison de tension, de manière à acheminer un signal de tension d'entrée directement à l'interface (190) de sortie.

11. Système (100) de modification d'une pluralité de signaux de mesure de test de dispositif de protection de réseaux électriques, le système comportant
une pluralité de montages (100a) suivant l'une des revendications précédentes.

12. Procédé de modification de signaux de mesure de test de dispositif de protection de réseaux électriques, en utilisant un montage (100a) d'adaptation, notamment un montage (100a) suivant l'une des revendications 1 à 10 précédentes, le procédé comportant
l'envoi d'un premier signal de mesure de test, d'un générateur de test à une interface (110) d'entrée du montage (100a) d'adaptation, le premier signal de mesure de test étant adapté à une première caractéristique électrique d'entrée d'un premier dispositif de protection d'un réseau ;
la transformation du premier signal de mesure de test en un deuxième signal de mesure de test, en utilisant un système (130) électrique de modification connecté à l'interface (110) d'entrée, le deuxième signal de mesure de test étant adapté à une deuxième caractéristique électrique d'entrée d'un deuxième dispositif de protection du réseau ; et
l'envoi du deuxième signal de mesure de test au deuxième dispositif de protection par une interface (190) de sortie du montage (100a) d'adaptation.
